# FASCICULE DE BREVET EUROPEEN

(11) **EP 0 462 030 B1**
(45) Date de publication et mention de la délivrance du brevet: **14.09.1994**
(21) Numéro de dépôt: 91420184.3
(22) Date de dépôt: 07.06.1991
(51) Int. Cl.: H01L 21/00

(54) **Conteneur pour plaquette semiconductrice**
Behälter für Halbleiterplättchen
Container for semiconductor wafers

(30) Priorité: 12.06.1990 FR 9007542
(43) Date de publication de la demande: 18.12.1991
(73) Titulaire: SGS-THOMSON MICROELECTRONICS S.A., 94250 Gentilly (FR)
(72) Inventeur: Skoura, Gilles, F-38000 Grenoble (FR)
(74) Mandataire: de Beaumont, Michel

(56) Documents cités:
- DE-U- 8 801 235
- US-A- 3 661 253

## Description

La présente invention concerne, de façon générale, des conteneurs destinés au transport et à la manutention de plaquettes en matériau semiconducteur, et plus précisément un conteneur destiné à enfermer une seule plaquette.

Il existe déjà des conteneurs destinés à enfermer une seule plaquette en matériau semiconducteur. De tels conteneurs sont en général utilisés pour effectuer le transport et la manutention des plaquettes, en assurant leur protection physique. Ces plaquettes peuvent être vierges, partiellement traitées, ou complètement traitées et comporter des circuits intégrés.

Les conteneurs pour plaquettes en matériau semiconducteur connus actuellement sont constitués de deux pièces, une première pièce constituant le fond, présentant la forme générale d'un disque, et une seconde pièce, de forme semblable, constituant le couvercle. Dans ce type de conteneur, le couvercle et le fond présentent des surfaces périphériques de révolution conjuguée, permettant l'emboîtement de ces deux pièces. Cet emboîtement peut présenter un certain jeu, c'est-à-dire être libre, ou peut être légèrement forcé, afin d'assurer une liaison entre le couvercle et le fond. Cet emboîtement peut permettre d'assurer un verrouillage du couvercle sur le fond, en particulier sous l'effet d'un mouvement de rotation du couvercle par rapport au fond.

Les conteneurs connus présentent toujours une certaine différence de forme entre fond et couvercle. Lorsque l'on veut charger des plaquettes dans de tels conteneurs, on est obligé de fabriquer puis de gérer simultanément deux ensembles de pièces, un ensemble constitué de fonds et un autre ensemble constitué des couvercles. Comme les fonds et les couvercles sont en général constitués du même matériau, en particulier d'une matière plastique, et comme, par ailleurs, les fonds et les couvercles sont de forme relativement semblable, il est difficile de les reconnaître et des interversions peuvent être commises.

Etant donné que les opérations de manutention visant à charger des plaquettes dans des conteneurs ou à les décharger, sont souvent effectuées de façon robotisée, le fait de gérer séparément les fonds et les couvercles complique le fonctionnement du robot. Il est également difficile pour un robot de disposer un couvercle sur un fond en ajustant de façon précise la position angulaire relative de ces deux pièces. Pour effectuer une telle manoeuvre, le robot doit repérer la position angulaire du fond, repérer la position angulaire du couvercle et faire tourner l'une de ces deux pièces en conséquence. La réalisation de ces fonctions relativement complexes est sujette à certaines défaillances et nécessite un équipement coûteux.

Un objet de la présente invention est de prévoir un conteneur pour plaquette en matériau semiconducteur permettant un emboîtement du couvercle sur le fond sans nécessiter d'ajuster la position angulaire du couvercle par rapport au fond.

Un autre objet de la présente invention est de prévoir un tel conteneur conçu de façon à éviter d'avoir à reconnaître un couvercle d'un fond lors du changement d'une plaquette dans le conteneur.

Un autre objet de la présente invention est de prévoir un conteneur dont le fond et le couvercle sont identiques et empilables.

Pour atteindre ces objets, la présente invention prévoit un conteneur pour plaquette semiconductrice comprenant deux pièces, l'une formant fond et l'autre formant couvercle, dans lequel ces deux pièces ont une forme identique, chaque pièce ayant la forme générale d'un disque définissant un axe central et comportant sur une première face un grand nombre de protubérances disposées sur un cercle périphérique et constituées de surfaces planes inclinées par rapport au plan du disque se rejoignant selon des arêtes supérieures et inférieures orientées radialement par rapport à l'axe central pour former une couronne crénelée.

Selon un mode de réalisation de la présente invention, un épaulement périphérique est formé sur la première face, à l'intérieur de la couronne, permettant le logement et le positionnement de la plaquette.

Selon un mode de réalisation de la présente invention, une encoche latérale dans la couronne et l'épaulement permet de glisser sous une plaquette posée sur une pièce formant le fond du conteneur un outil de préhension de la plaquette.

Selon un mode de réalisation de la présente invention, les pièces sont en matière plastique, de préférence en un matériau anti-statique.

Selon un mode de réalisation de la présente invention, la deuxième face de chaque pièce comporte une nervure à l'intérieur de la couronne pour assurer le blocage des pièces quand elles sont empilées.

Ces objets, caractéristiques et avantages, ainsi que d'autres de la présente invention seront exposés plus en détail dans la description d'un mode de réalisation qui va suivre, illustrée par des figures annexées parmi lesquelles :
la figure 1 est une demi-vue en coupe d'un mode de réalisation d'un conteneur selon l'invention, disposé dans une position de fermeture, refermant une plaquette en matériau semiconducteur;
la figure 2 est une vue en perspective d'une pièce d'un conteneur selon l'invention ; cette vue étant simplifiée, de façon à ne représenter en détail que la forme des protubérances en dents de scie qui constituent l'une des caractéristiques de l'invention ;
la figure 3 est une demi-vue en coupe transversale d'un empilement des pièces constituant des conteneurs correspondant à celui représenté en figure 1 ;
la figure 4 est une vue de dessus d'un autre mode de réalisation d'un conteneur selon l'invention ; et
la figure 5 est une vue en coupe partielle agrandie selon la ligne A-A de la figure 4, cette vue représentant un moyen destiné à saisir une plaquette posée dans le conteneur.

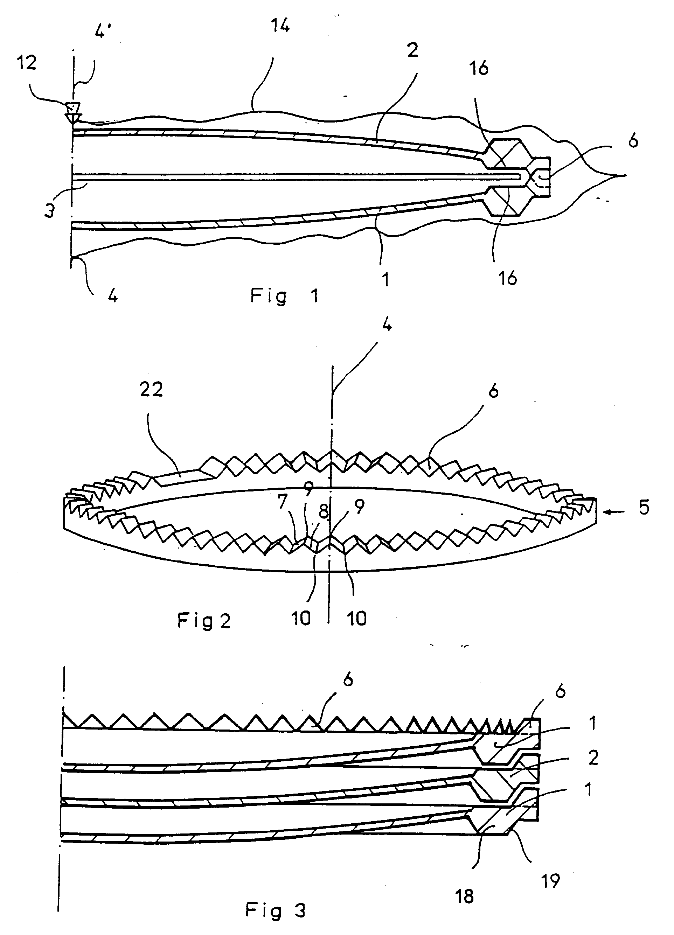

La figure 1 représente un conteneur constitué de deux pièces identiques 1 et 2, l'une, 1, formant un fond et l'autre, 2, formant un couvercle. Le conteneur est en position fermée, le couvercle 2 étant posé sur le fond 1. Avant de poser le couvercle sur le fond, on dispose une plaquette en matériau semiconducteur 3 sur la place supérieure du fond 1, puis on pose le couvercle 2 par dessus, en prenant soin que l'axe central 4 du couvercle soit peu écarté de l'axe central 4′ du fond.

Chaque pièce 1, 2 a la forme générale d'un disque et est, de préférence, en matière plastique moulée. Lorsque l'on pose le couvercle 2 sur le fond 1, certaines surfaces conjuguées appartenant respectivement à ces deux pièces viennent en contact pour assurer un centrage du couvercle par rapport au fond, ainsi qu'un blocage des deux pièces destinées à éviter leur déplacement relatif dans un plan perpendiculaire à leur axe central 4, 4′, tant qu'une certaine force est excercée pour presser le couvercle contre le fond. Ces formes conjuguées présentent la particularité d'être parfaitement identiques, qu'elles appartiennent au fond 1 ou au couvercle 2.

La figure 2 représente plus en détail les formes conjuguées 5. Les formes conjuguées 5 sont disposées sur un cercle périphériques et sont constituées d'une suite de protubérances équidistantes 6 formant un profil en dents de scie. Les protubérances 6 sont orientées suivant l'axe central 4 de la pièce. Chaque protubérance 6 a la forme d'un dièdre constitué de deux flancs plans 7, 8 inclinés par rapport au plan du disque. Ces flancs 7, 8 se rejoignent vers le haut pour former une arête supérieure 9 et se rejoignent vers le bas pour former une arête inférieure 10. Les arêtes supérieures et inférieures 9, 10 sont disposées radialement par rapport à l'axe central 4. Le profil en dents de scie s'étend ainsi de façon circonférencielle sur les deux pièces du conteneur. Lorsque les deux pièces 1, 2 sont posées l'une sur l'autre, les deux profils en dents de scie s'interpénètrent et établissent une liaison entre les deux pièces 1, 2, cette liaison s'opposant au déplacement relatif des deux pièces dans un plan perpendiculaire à l'axe central 4. En effet, quelle que soit l'orientation d'un effort s'exerçant perpendiculairement à l'axe central 4 sur l'une des pièces 1, 2 du conteneur, il existe toujours au niveau de la bande circonférentielle 5 un certain nombre de protubérances 6 dont les arêtes 9, 10 sont orientées sensiblement perpendiculairement à la direction de cet effort. Ces protubérances 6 s'opposent alors au déplacement relatif des pièces 1 et 2 pour autant qu'une certaine pression est excercée (flèche 12) d'une pièce 2 contre l'autre pièce 1.

Par ailleurs, il n'est pas nécessaire de positionner de façon parfaitement concentrique les deux pièces 1, 2 lorsque l'on vient les assembler pour former le conteneur.

En effet, s'il existe lors de cette opération un léger décalage entre les positions relatives des axes centraux 4 et 4′ des deux pièces 1, 2, les protubérances 6 en forme de dents de scie présentes sur chacune des deux pièces 1, 2 entrent en contact et les flancs inclinés 7, 8 glissent les uns sur les autres et recentrent ainsi automatiquement les deux pièces 1, 2. Bien entendu, l'écart entre les deux axes centraux 4 et 4′ doit être inférieur à la distance d séparant, dans un plan perpendiculaire à l'axe central 4, une arête supérieure 9 de l'arête inférieure consécutive 10.

De même, s'il existe un décalage en rotation entre une arête supérieure 9 d'une pièce et une arête inférieure de la pièce en vis à vis, le recentrage se fait automatiquement sous l'action de la gravité dès qu'une pièce est posée sur l'autre.

Pour le conditionnement d'une plaquette 3 présentant un diamètre d'environ 100, 125 ou 150 mm, les protubérances 6 peuvent être à un pas d'environ 4 mm et avoir une étendue radiale d'environ 3mm. Pour une telle conformation, l'écart entre les axes centraux 4 et 4′ lors du montage des deux pièces 1, 2 peut atteindre une valeur de l'ordre de 2 mm. On peut facilement obtenir une telle précision de positionnement en utilisant un robot.

Les deux pièces 1, 2 formant un conteneur peuvent être maintenues en position de fermeture en exerçant une certaine force (flèche 12) pour les rapprocher l'une de l'autre. On peut se servir de la pression atmosphérique pour créer une telle force de façon permanente. Pour cela, lorsque l'on a posé une plaquette 3 sur un fond 1 et un couvercle 2 par dessus, on insère cet ensemble dans une poche en matière plastique souple 14, puis on crée le vide à l'intérieur de cette poche et on la scelle de façon hermétique. Dans ces conditions, la pression atmosphérique exerce de façon permanente une pression de part et d'autre des pièces 1 et 2 constituant le conteneur, assurant leur liaison.

De préférence, chaque pièce 1, 2 comporte un épaulement périphérique 16 permettant le support d'une plaquette 3. Les épaulements 16 peuvent avoir une dimension telle qu'il reste un certain jeu entre la plaquette 3 enfermée dans le conteneur et ces épaulements. Dans ce cas, la plaquette 3 peut bouger légèrement lorsqu'elle est enfermée dans le conteneur. On peut aussi prévoir des dimensions des épaulements 16 telles que, lorsque la plaquette 3 est enfermée dans le conteneur, les deux surfaces 16 en regard viennent s'appliquer sur la périphérie des faces opposées de la plaquette, de façon à immobiliser celle-ci.

Les pièces 1, 2 constituant un conteneur peuvent présenter une forme permettant leur empilement lorsqu'elles sont toutes disposées dans le même sens. La figure 3 représente trois pièces de conteneur empilées les unes sur les autres. Pour pouvoir être empilées, les pièces 1, 2 comportent sur leur face extérieure une nervure circulaire 18 ayant une surface extérieure de diamètre sensiblement égal au diamètre intérieur de la zone à dents de scie 6. Les surfaces extérieure 19 et intérieure 17 sont d'une conicité complémentaire pour faciliter l'emboîtement.

Grâce à l'invention, on peut fabriquer un seul type de pièces et alimenter un robot à partir d'une seule pile de pièces. Le robot saisit une première pièce qu'il dispose horizontalement, puis il saisit une plaquette qu'il pose dans cette première pièce, et enfin il saisit une autre pièce de la pile qu'il retourne pour la poser au-dessus de la première pièce.

On peut aussi prévoir deux piles de pièces, ces deux piles étant disposées en sens opposé l'un par rapport à l'autre. Dans ce cas, le robot saisit une pièce de la première pile, pose une plaquette sur cette pièce (qui constitue un fond), puis saisit une pièce de la seconde pile et pose cette seconde pièce (qui constitue un couvercle) sur la première pièce. Dans ce cas, le robot n'a pas besoin de disposer d'un moyen permettant de retourner une pièce du conteneur. Bien que l'on alimente le robot avec deux piles différents, l'une destinée à constituer les fonds, l'autre destinée à constituer les couvercles, le fait que ces deux piles sont constituées de pièces identiques permet de simplifier la gestion de ces piles de pièces.

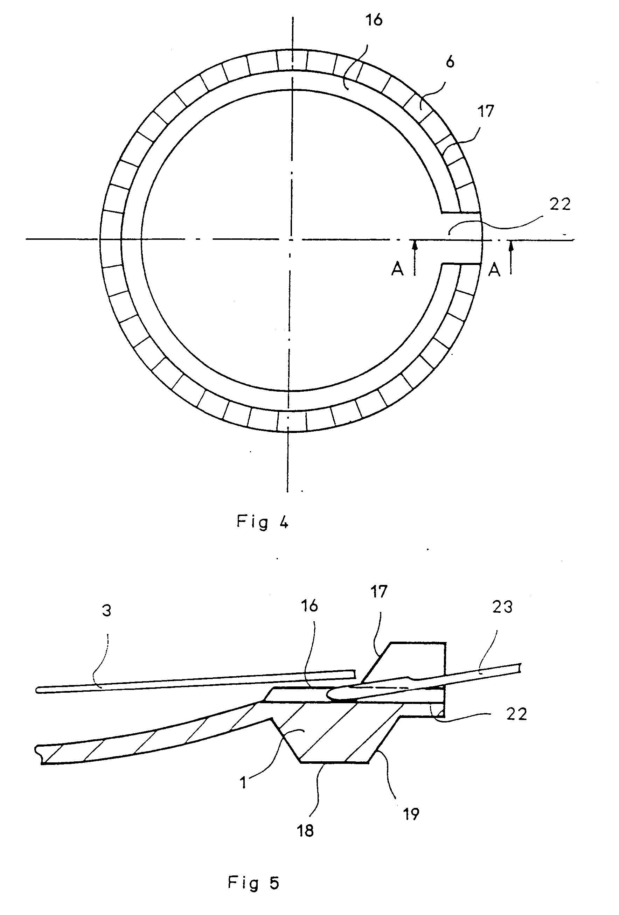

La figure 4 représente en vue de dessus une pièce 1 ou 2 de conteneur. Une encoche 22 est ménagée latéralement. Cette encoche est également illustrée en figure 5. L'encoche 22 permet de glisser une pipette à vide 23 sous une plaquette 3 posée sur l'épaulement 16, afin de la saisir par sa face arrière. L'encoche 22 entraîne la suppression d'un petit nombre de protubérances 6. Le nombre de protubérances supprimé étant relativement faible, cela n'entraîne aucun disfonctionnement du mode d'emboîtement et de positionnement des deux pièces 1, 2 constituant un conteneur.

De préférence, les pièces constituant un conteneur sont réalisées en une matière plastique anti-statique, c'est-à-dire présentant une certaine conductivité électrique. Les matières plastiques anti-statiques sont en général noires et opaques. Dans ce cas, puisque les fonds et les couvercles sont parfaitement identiques, il peut être utile d'apposer sur le fond ou le couvercle une étiquette indiquant quelle est la face supérieure de la plaquette 3 enfermée dans le conteneur. On peut aussi apposer une telle étiquette sur la poche plastique 14 qui renferme le conteneur.

Lors du montage ou du démontage d'un conteneur selon l'invention les pièces du conteneur venant en contact ne frottent pas de façon excessive l'une par rapport à l'autre, mais sont simplement posées l'une sur l'autre et glissent au niveau des flancs inclinés des protubérances 6 du fait de la gravité. Cela entraîne des frictions extrêmement limitées qui ne génèrent pratiquement pas de particules ni de phénomènes d'usure. La propreté des conteneurs aussi constitués n'est par conséquent pas dégradée par l'opération de montage.

## Revendications

1. Conteneur pour plaquette semiconductrice comprenant deux pièces, l'une formant fond et l'autre formant couvercle, caractérisé en ce que ces deux pièces (1, 2) ont une forme identique et en ce que chaque pièce a la forme générale d'un disque définissant un axe central (4) et comporte sur une première face un grand nombre de protubérances (6) disposées sur un cercle périphérique et constituées de surfaces planes inclinées par rapport au plan du disque se rejoignant selon des arêtes supérieures (9) et inférieures (10) orientées radialement par rapport à l'axe central (4) pour former une couronne crénelée.

2. Conteneur selon la revendication 1, caractérisé en ce qu'il comporte un épaulement périphérique (16) sur ladite première face, à l'intérieur de ladite couronne, permettant le logement et le positionnement de la plaquette (3).

3. Conteneur selon la revendication 2, caractérisé en ce qu'il comporte une encoche latérale (22) dans la couronne et l'épaulement permettant de glisser sous une plaquette (3) posée sur une pièce (1) formant le fond du conteneur un outil (23) de préhension de la plaquette.

4. Conteneur selon la revendication 1, caractérisé en ce que les pièces (1, 2) sont en matière plastique.

5. Conteneur selon la revendication 4, caractérisé en ce que les pièces (1, 2) sont en un matériau anti-statique.

6. Conteneur selon la revendication 1, caractérisé en ce que la deuxième face de chaque pièce comporte une nervure à l'intérieur de ladite couronne pour assurer le blocage des pièces quand elles sont empilées.

7. Conteneur selon la revendication 1, caractérisé en ce qu'il est entouré d'un sac en matière plastique souple scellé sous vide.

## Patentansprüche

1. Behälter für Halbleiterplättchen aus zwei Teilen, wobei das eine Teil einen Boden und das andere einen Deckel bilden, dadurch gekennzeichnet, daß die zwei Teile (1, 2) identische Form aufweisen, und daß jedes Teil allgemein die Form einer Scheibe mit einer Mittelachse (4) aufweist und auf einer ersten Seite eine große Anzahl von Vorsprüngen (6) trägt, die längs eines Kreises an der Peripherie angeordnet sind und ebene, in bezug zur Scheibenebene geneigte Oberflächen aufweisen, die an oberen (9) und unteren (10) Kanten zusammenstoßen, welche sich radial in bezug zur Mittelachse (4) erstrecken, so daß eine Sägezahnkrone gebildet wird.

2. Behälter nach Anspruch 1, dadurch gekennzeichnet, daß er an der Peripherie eine Schulter (16) auf der ersten Oberfläche innerhalb der Krone trägt, die die Aufnahme und Positionierung des Plättchens (3) erlaubt.

3. Behälter nach Anspruch 2, dadurch gekennzeichnet, daß er in der Krone und in der Schulter eine seitliche Aussparung (22) aufweist, um unterhalb eines Plättchens (3), das auf einem den Boden des Behälters bildenden Teiles (1) angeordnet ist, ein Werkzeug (23) zum Greifen des Plättchens einzuführen.

4. Behälter nach Anspruch 1, dadurch gekennzeichnet, daß die Teile (1, 2) aus Plastikmaterial sind.

5. Behälter nach Anspruch 4, dadurch gekennzeichnet, daß die Teile (1, 2) aus einem antistatischen Material sind.

6. Behälter nach Anspruch 1, dadurch gekennzeichnet, daß die zweite Seite jedes Teiles innerhalb der Krone eine Rippe aufweist, um aufeinander gestapelte Teile in ihrer Lage zu fixieren.

7. Behälter nach Anspruch 1, dadurch gekennzeichnet, daß er von einer vakuumversiegelten Hülle aus flexiblem Plastikmaterial umgeben ist.

## Claims

1. A semiconductor wafer container comprising two parts, one forming the bottom and the other forming the lid, characterized in that these two parts (1, 2) are identical and each part substantially forms a disk defining a central axis (4), each part comprising on a first surface a plurality of protruding parts (6) arranged according to a peripheral circle and constituted by plane surfaces, slanted with respect to the plane of the disk, joining according to upper (9) and lower (10) edges radially oriented with respect to the central axis (4) for forming a saw-tooth ring.

2. A container according to claim 1, characterized in that it comprises a peripheral shoulder (16) on said first surface, inside said ring, for accommodating and positioning the wafer (3).

3. A container according to claim 2, characterized in that it comprises a lateral notch (22) in said ring and said shoulder for inserting, under a wafer (3) posed on a part (1) forming the bottom of the container, means (23) for gripping said wafer.

4. A container according to claim 1, characterized in that said parts (1, 2) are made of a plastics material.

5. A container according to claim 4, characterized in that said parts (1, 2) are made of an antistatic material.

6. A container according to claim 1, characterized in that the second surface of each part comprises a groove inside said ring for blocking the parts when they are piled up.

7. A container according to claim 1, characterized in that it is surrounded by a vacuum sealed flexible envelope made of a plastics material.
